# EUROPÄISCHE PATENTSCHRIFT

(11) **EP 0 859 467 B1**
(45) Veröffentlichungstag und Bekanntmachung des Hinweises auf die Patenterteilung: **17.04.2002**
(21) Anmeldenummer: 98101516.7
(22) Anmeldetag: 29.01.1998
(51) Int. Cl.: H03K 17/96

(54) **Berührungsschalter mit Sensortaste**
Touch switch with sensor key
Commutateur à effleurement avec capteur à touche

(30) Priorität: 17.02.1997 DE 19706168; 29.11.1997 DE 29721212 U
(43) Veröffentlichungstag der Anmeldung: 19.08.1998
(73) Patentinhaber: E.G.O. ELEKTRO-GERÄTEBAU GmbH, 75038 Oberderdingen (DE)
(72) Erfinder: Platt, Nils, 74374 Zaberfeld-Leonbronn (DE); Schilling, Wilfried, 76703 Kraichtal (DE); Götz, Bernhard, 75059 Zaisenhausen (DE); Kreiter, Uwe, 75038 Oberderdingen (DE)
(74) Vertreter: Patentanwälte Ruff, Wilhelm, Beier, Dauster & Partner

(56) Entgegenhaltungen:
- EP-A- 0 286 747
- EP-A- 0 595 532
- DE-A- 3 119 495
- US-A- 3 951 250
- US-A- 4 322 983
- BURK A: "MOMENTARY SWITCHING ALTERNATIVES FOR KEY PAD AND FRONT PANEL APPLICATIONS" ELECTRO INTERNATIONAL CONFERENCE RECORD, Bd. 18, 1.Januar 1993, Seiten 282-291, XP000381927

## Beschreibung

Die Erfindung betrifft einen Berührungsschalter mit einer Sensortaste.

Bei vielen elektrischen oder elektrisch gesteuerten Anlagen, Apparaten und Geräten werden anstelle mechanischer Schalter sogenannte Berührungsschalter eingesetzt, die z.B. durch bloße Berührung oder Annäherung eines Fingers betätigt werden. Die eigentliche Schaltfunktion wird dabei von elektronischen Schaltern oder Relais' ausgeführt, die in Auswirkung der Berührung der Sensortaste des Berührungsschalters angesteuert wird. Diese Schalter werden häufig an Fahrstühlen oder für ähnliche Zwecke eingesetzt. Auch zur Steuerung von Elektrokochgeräten werden sie verwendet. Dabei ergibt sich der Vorteil, daß insbesondere bei Glaskeramikkochgeräten die Betätigung durch die geschlossene Glaskeramikplatte hindurch erfolgen kann, hier also keine Durchbrüche nötig sind.

Die Sensorelemente bekannter Berührungsschalter sind meist einzeln oder zu mehreren in Form metallisierter Felder auf Platten, beispielsweise in Leiterplatten vorgesehen, die durch Metallfedern an die Unterseite der Abdeckplatte, also beispielsweise eine Hartglas- oder Glaskeramikplatte eines Kochgerätes, angedrückt werden. Die Anordnung der Metallfedern, die Anpassung der Sensortaste an die Abdeckplatte sowie Montage- und Transportprobleme erschweren die Anwendung.

Die DE 31 19 495 offenbart einen kapazitiven Annäherungs-Schalter unter einer Abdeckplatte aus Glas. Die kapazitive Sonde des Schalters weist eine metallische Stütze auf, die mit einer Schicht aus leitendem Schaumstoff belegt ist. Diese Schaumstoffschicht wird an die Unterseite der Abdeckung angelegt und soll eine optimale Anpassung der kapazitiven Sonde an die Unterseite der Abdeckplatte bewirken. Somit soll ein Luftspalt zwischen kapazitiver Sonde und Abdeckplatten-Unterseite vermieden werden, der die Funktion des Annäherungs-Schalters negativ beeinträchtigen würde. Derartige Luftspalte können beispielsweise durch nicht planparallele Montage der flächigen Sonde zur Abdeckplatte oder durch Unebenheiten an der Unterseite der Abdeckplattehervorgerufen werden.

Die Veröffentlichtung "Momentary Switching Alternatives Key Pad and Front Panel Applications" beschreibt Druckschalter mit jeweils ohmschen Kontakten. Dabei sind zwar die Träger eines oder beider Kontakte aus flexiblen Materialien bzw. Kunststoffen hergestellt, das Funktionsprinzip beruht jedoch auf dem Schließen zweier Kontakte bzw. Kontaktfelder. Die Elastizität erfüllt lediglich den Zweck, daß die Bewegbarkeit der Kontakte ermöglicht wird.

Die EP 595 532 offenbart ein elastisches Kunststoffmaterial für einen Scherungssensor, das eine elektrische Leitfähigkeit sowie ferritische Materialeinschlüsse aufweist. Die ferritischen Eigenschaften bzw. magnetischen Teilchen werden gebraucht, um die leitfähigen Partikel in dem noch weichen bzw. nicht verfestigten Einhüllungsmaterial durch Anlegen eines magnetischen Feldes auf gewünschte Weise ausrichten zu können.

### AUFGABE UND LÖSUNG

Aufgabe der Erfindung ist es, einen gegenüber dem Stand der Technik verbesserten Berührungsschalter mit einer Sensortaste zu schaffen, der einfacher herstellbar und montierbar ist, der insbesondere beim Transport und im Betrieb keine Probleme macht und auch bzgl. der Wirksamkeit verbessert ist.

Diese Aufgabe wird durch die Merkmale des Anspruchs 1 gelöst. Die Sensortaste ist erfindungsgemäß ein in sich flexibler, räumlich ausgedehnter, raumformveränderlicher und elektrisch leitender Körper und weist einen nicht unerheblichen eigenen elektrischen Widerstand zur Dämpfung von elektrischen Störgrößen auf. Bevorzugt besteht die Sensortaste aus einem elektrisch leitfähigen Kunststoff- oder Gummimaterial, das insbesondere nach Art eines Blocks vorliegt, worunter auch voluminöse Körper zu verstehen sind, die z.B. die Form von Quadern, Ringen oder Hohlzylindern o.dgl. haben. Besonders bevorzugt besteht sie aus elektrisch leitfähigem Schaumstoff. Es eignen sich dafür insbesondere weichelastische Kunststoffe, Kunstgummi oder Naturgummi, die mit Kohlenstoff-(Ruß-), Metall- oder ähnlichen Einlagerungen elektrisch leitfähig gemacht sind. Für höhere Temperaturen sind u.a. Silicone gut geeignet, die sich, ebenso wie andere weichelastische Kunststoffe, gut schäumen lassen. Die Sensortaste braucht also nur ein entsprechend geformtes Stück aus diesem Material zu sein, z.B. ein Zylinder, das von unten an die Abdeckung bzw. die Abdeckplatte, angedrückt wird. Dabei entsteht der Vorteil, daß die Sensortaste an der Abdeckung satt anliegt, auch wenn diese uneben sein sollte. Insbesondere die Unterseiten von Glaskeramikplatten bei Strahlungskochherden haben oft eine Profilierung oder Riffelung. Diese erzeugt bei starren Sensortasten einen die Wirksamkeit verringernden Spalt, während sich die flexible Sensortaste nach der Erfindung satt anlegen kann. Die nötige Federwirkung, die für das Anlegen notwendig ist, ergibt sich vorzugsweise aus der Eigenelastizität des Körpers.

Bei einer bevorzugten Ausführung der Erfindung weist die Sensortaste wenigstens einen Durchbruch auf, der vorzugsweise in eine äußere Begrenzungsfläche der Sensortaste mündet, die zu einer Abdeckung oder einem Betätigungsfeld des Berührungsschalters hin weist. Durch einen derartigen Durchbruch wird eine Vielzahl von Funktionsmerkmalen und Ausgestaltungsmöglichkeiten der Sensortaste bzw. des Berührungsschalters ermöglicht. Eine bevorzugte Möglichkeit, die zur Kennzeichnung des Berührungsschalters bzw. der Sensortaste dienen kann, sieht vor, in dem Durchbruch Leuchtmittel anzuordnen, also beispielsweise LEDs, Glühlampen oder andere lichtführende Bauteile wie Lichtleiter. Der Durchbruch ist dabei vorzugsweise im wesentlichen geradlinig, insbesondere mit im wesentlichen konstantem Querschnitt, ausgeführt.

Aufgrund von Wärmeentwicklung und Leistungsverbrauch werden bevorzugt LEDs oder Lichtleiter eingesetzt. LEDs bieten den Vorteil einer individuell auf jeden Berührungsschalter abgestimmten Beleuchtung, mit allen sich daraus ergebenden Möglichkeiten für Änderungen einer Beleuchtung bzgl. Intensität und/oder Dauer. So können mit einem derartigen Berührungsschalter durch Leuchtzeichen dem Benutzer gewisse Schaltzustände bzw. -möglichkeiten signalisiert werden, ebenso wie eine Benutzerführung. Bei einer Steuerung für einen elektrischen Herd beispielsweise werden nur die Berührungsschalter beleuchtet, die zu dem jeweiligen Zeitpunkt eine erlaubte Funktion ausüben können. Es können ebenfalls Kombinationen mehrerer Leuchtmittel eingesetzt werden, beispielsweise Lichtleiter für eine permanente Beleuchtung, evtl. abhängig von der Helligkeit der Umgebung, und LEDs für die individuelle und vom Betätigungszustand abhängige Kennzeichnung.

Bei einer weiteren Ausführung der Erfindung kann eine Ausnehmung, insbesondere an einer dem Betätigungsfeld zugewandten Begrenzungsfläche mit dem Durchbruch, an der Sensortaste zur Befestigung und/oder Aufnahme einer Schablonenscheibe mit einem ein Symbol darstellenden Ausschnitt oder mit verschiedenartig lichtdurchlässigen Einsätzen vorgesehen sein. Auf diese Weise stellt eine derartige Sensortaste nicht nur eine diffuse Lichtquelle dar, sondern etwa ein beleuchtetes Symbol, das beispielsweise durch eine Glaskeramikplatte eines Kochgerätes hindurch als solches deutlich erkennbar ist. Einem Benutzer wird auf elegante und doch sehr reizvolle Weise die Bedeutung eines derartig ausgeführten Berührungsschalters verdeutlicht. Ebenso ist es möglich, daß der lichtabstrahlende Körper der Leuchtmittel eine einem Symbol entsprechende Form aufweist, was besonders bei LEDs möglich ist. Eine Kennzeichnung dieses Berührungsschalters mittels Aufdrucken auf oder unter der Abdeckung kann somit entfallen. Sowohl ein Durchbruch als auch darin befindliche Leuchtmittel, evtl. mit einer beschriebenen Symbolscheibe, beeinträchtigen die Eigenschaften der Sensortaste bei geeigneter Dimensionierung nicht oder nur in unwesentlichem Maß.

Die Sensortaste ist auch leicht anzubringen. Sie kann beispielsweise mittels eines leitfähigen Klebers oder Doppelklebebandes angebracht werden, der die Sensortaste direkt auf einer die elektrischen Schaltungsbauteile für den Berührungsschalter enthaltenen Platine festlegt. Auch die Befestigung über einen an einer solchen Platine angelöteten Stift, der in die Sensortaste hineinragt, ist möglich. Ebenso ist eine Befestigung dadurch möglich, daß bei einer Ausführung mit Durchbruch die Sensortaste einfach über eine dazu bemessene LED o.dgl. gestülpt wird und so fixiert wird, bis sie bei der Endmontage zwischen Unterlage und Abdeckung eingespannt wird.

Die Sensortaste kann einen nicht unerheblichen elektrischen Widerstand aufweisen, z.B. bis zu 500 Kiloohm. Sie ist nur einseitig elektrisch angeschlossen und bildet praktisch einen Pol eines Kondensators, der durch den sich nähernden Finger der Bedienungsperson in seiner Kapazität verändert wird. Der unter Umständen nicht unerhebliche elektrische Widerstand des Materials der Sensortaste wirkt sich auf die Eigenschaft des Berührungsschalters eher positiv aus. Dadurch wird bei der kapazitiven Kopplung durch das Glas an den menschlichen Finger eine sehr gute Filterwirkung gegenüber elektrischen Störgrößen erzielt. Dies ist sehr wichtig für die ständig zunehmende EMV-Problematik. Die Filterwirkung wird hauptsächlich gegen die Einstrahlung von HF-Störgrößen erreicht, aber auch eine eigene Störausstrahlung kann dadurch vermieden aber auch eine eigene Störausstrahlung kann dadurch vermieden bzw. verringert werden. Es wird somit ein R-C- und/oder L-C-Filter gebildet.

Infolge der satten Anlage an der Abdeckplatte entsteht nur eine geringe Streukapazität. Die Druckspannung zwischen der Unterlage und der Abdeckplatte, die auf die Sensortaste wirkt, sollte im Betrieb aufrecht erhalten werden, um die plane Anlage dauerhaft zu gewährleisten.

Durch die Beimischung ferritischer Materialien kann die Sensortaste ferritische Eigenschaften bekommen, die den induktiven Widerstandsanteil des Sensors verbessern und dadurch eine weitere Verbesserung der elektromagnetischen Verträglichkeit (EMV-Eigenschaften) bewirken.

Es ist zu erkennen, daß ein Berührungsschalter mit einer Sensortaste nach der Erfindung zahlreiche Vorteile aufweist. Die Sensortaste kann einfach als ein einstückiger Körper hergestellt werden, ist außerordentlich kostengünstig und leicht zu montieren, z.B. durch Klebung oder durch Aufstecken. Jede Sensortaste kann leicht als ein Einzelkörper ausgebildet sein, dessen Plazierung durch seine Unterlage, z.B. die Platine, bestimmt ist. Das erleichtert auch die genaue und spaltfreie Anlage an der Glasunterseite. Dennoch braucht die Federkraft zum Erreichen einer guten satten Anlage nur sehr gering zu sein. Die Oberfläche der Sensortaste ist meist oxidationsfrei und in Bezug auf die Wirksamkeit kaum feuchtigkeitsempfindlich. Gerade auch bei Anwendungen im Elektrowärmebereich ist es ein Vorteil, daß das Sensorelement selbst gute thermische Dämmeigenschaften hat. Es schützt also die Elektronik vor unzulässiger Erwärmung auch bei einer Fehlplazierung eines heißen Kochgefäßes auf der Sensorfläche.

Weitere Vorteile ergeben sich bei der Montage. Die einzelnen Sensortasten können z.B. Montageautomaten in Stangenform zugeführt und an Ort und Stelle abgelängt werden. Aber auch die gegurtete oder als Schüttgut vorliegende Form ist leicht zu montieren, auch in Montageautomaten. Ferner könnte die Sensortaste auf einer die Klebeschicht abdeckenden Schutzfolie der Montage zugeführt werden. Der Transport sowohl während als auch nach der Montage des Berührungsschalters wird durch die fehlenden sperrigen Metallfedern vereinfacht.

Diese und weitere Merkmale gehen außer aus den Ansprüchen auch aus der Beschreibung und den Zeichnungen hervor. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen dargestellt und wird im folgenden näher erläutert. In den Zeichnungen zeigen:
- Fig. 1: den senkrechten Schnitt durch eine Glaskeramikplatte mit darunter angeordnetem Berührungsschalter-Feld,
- Fig. 2: einen eine Sensortaste bildenden Körper im nichtmontierten Zustand (Seitenansicht und Draufsicht);
- Fig. 3 bis 5: Sensortasten im Einbauzustand, jeweils in Seitenansicht (bzw. -schnitt) und Draufsicht und
- Fig. 6: eine pilzförmige Sensortaste im montierten Zustand im Querschnitt mit Schablonenscheibe,
- Fig. 7: Draufsicht auf die Sensortaste aus Fig. 6,
- Fig. 8: Ansicht der Sensortaste aus Fig. 6 durch eine Glaskeramikplatte hindurch und
- Fig.9: das Ersatzschaltbild einer Sensortaste.

### Detaillierte Beschreibung der Ausführungsbeispiele

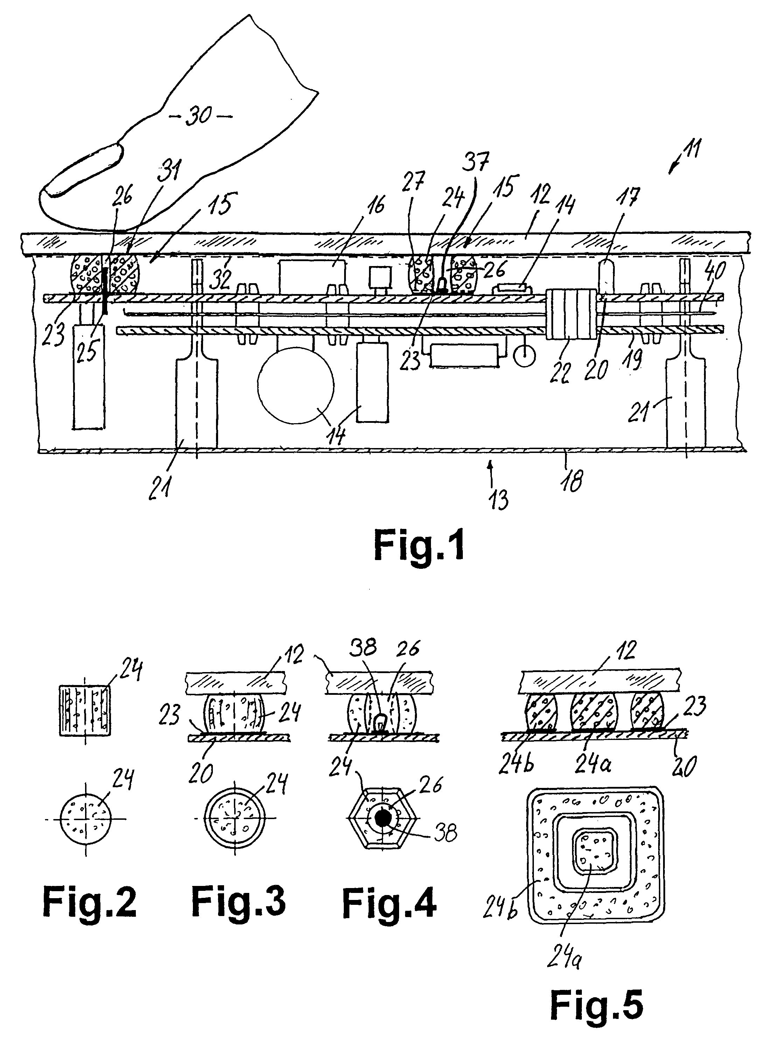

Fig. 1 zeigt einen vertikalen Schnitt durch einen Teil eines Kochgerätes 11 mit einer Glaskeramikplatte 12, unter der eine Steuer- oder Regeleinheit 13 angeordnet ist. Die Einheit 13 enthält elektronische und/oder elektromechanische Bauelemente 14 von Berührungsschaltern 15, Anzeigeeinrichtungen 16, 17 und andere Elemente, die für die Berührungsschalter und/oder andere Regel- und Steuergeräte für das Elektrokochgerät vorgesehen und ggf. zu Mehrzweck-Baugruppen zusammengefaßt sind.

In einem die Steuer- und Regeleinheit 13 gegen die übrige, Strahlheizkörper enthaltende Unterseite der Glaskeramikplatte abschirmenden Gehäuse 18 sind parallel zueinander zwei Platinen 19, 20 mittels Haltern 21 parallel zur Glaskeramikplatte 12 angeordnet. Sie sind als elektrische Leiterplatten ausgebildet und enthalten auf ihren voneinander abgekehrten Seiten, d.h. auf der Unterseite der unteren Leiterplatte 19 und auf der Oberseite der oberen Leiterplatte 20, die Bauelemente 14, und zwar vorzugsweise auf der unteren Leiterplatte die größeren Bauelemente, wie beispielsweise Relais' oder größere Kondensatoren, und auf der Oberseite kleinere Bauelemente, die beispielsweise mittels SMD-Technik aufgebracht sein können. Ferner sind auf der Oberseite die Anzeigeelemente vorgesehen, so eine Zahlenanzeige 16, beispielsweise ein 7-Segment-Display, und Leuchtdioden 17. Die Leiterebenen der beiden Platinen sind durch Flachkabel 22 oder andere Verbindungselemente miteinander verbunden. Ein elektrisch isolierendes Zwischenplättchen 40 kann zwischen den Platinen 19, 20 angeordnet sein.

Die obere Platine 20 weist an den zur Betätigung vorgesehenen Stellen metallische, mit den Leiterbahnen zusammen aufgebrachte Kontaktflächen 23 auf, auf denen Sensortasten 24 angebracht sind. Die Sensortasten 24 bestehen aus z.B. zylindrischen Körpern eines flexiblen, räumlich ausgedehnten, raumformveränderlichen, elektrisch leitfähigen Materials, wie auch in den Figuren 2 bis 6 dargestellt ist.

Der Körper der Sensortaste 24 kann aus flexiblem, also weichelastischem, Kunststoff oder Gummi bestehen, vorzugsweise in geschäumter Form, wobei das Material durch Einlagerungen elektrisch leitfähiger Materialien, beispielsweise Graphit (Ruß), Metallpulver oder anderer Medien elektrisch leitfähig gemacht ist. Fig. 1 zeigt auf der linken Seite, daß eine Sensortaste 24 mit einem in die Leiterplatte eingelöteten Stift 25 befestigt ist, der in einen vorbereiteten Durchbruch 26 in der Sensortaste eingesteckt ist und sie festlegt. Bei einem weicheren Schaumstoff könnte auch in das volle Material hineingestochen werden. Dieser Stift kann auch den elektrischen Anschluß verbessern. Etwa in der Mitte von Fig. 1 ist eine Sensortaste 24 dargestellt, die mittels eines leitfähigen Klebers 27 auf der Kontaktfläche 23 festgeklebt ist. Dies könnte auch ein leitfähiges doppelseitiges Klebeband sein. Auch sie weist einen durchgängigen Durchbruch 26 auf, in dem sich eine LED 37 befindet, die an der Platine auf nicht dargestellte Weise an die Steuer- oder Regeleinheit angeschlossen ist. Anstelle einer LED könnte auch eine Glühlampe oder ein Lichtleiter angeschlossen sein und zumindest teilweise in den Durchbruch 26 ragen.

Im Bereich des Durchbruchs 26 weist die Kontaktfläche 23 günstigerweise eine Aussparung mit den Abmessungen des Durchbruchs auf, so daß darin befindliche Leuchtmittel mit ihren elektrischen Anschlüssen keine unerwünschten Kontaktierungen oder gar Kurzschlüsse hervorrufen. Die Leiterbahnen für Leuchtmittel wie LED's sind bevorzugt auf der anderen Seite der Platine von den Kontaktflächen 23 vorgesehen, in diesem Fall auf der Unterseite der Platine 20.

Fig. 2 zeigt eine Sensortaste 24 vor ihrer Montage und Anbringung unter der Abdeckplatte 12. Sie ist in diesem Falle ein kreiszylindrischer Körper, der mit einer seiner Stirnflächen auf die Kontaktfläche aufgebracht werden kann, während die gegenüberliegende Stirnseite an der Unterseite einer Abdeckplatte anliegen kann.

Fig. 3 zeigt die Sensortaste 24 im Einbauzustand. Man erkennt, daß sie sich, weil sie unter einer gewissen Druckspannung an die Abdeckplatte 12 angelegt wird, tonnenförmig verformt. Die Andrückung kann unter konstanter Federkraft oder mit konstantem Abstand erfolgen. Wegen der guten Federwirkung des Materials der Sensortaste ist in jedem Falle eine ausreichende Wirkung sichergestellt.

Fig. 4 zeigt eine Sechseck-Ausführung, d.h. der Grundkörper hat die Form eines Zylinders mit sechseckiger Grundfläche. Dementsprechend erhält die Sensortaste 24 eine sechseckige Tonnenform bei ihrem Einsatz. Hier ist ebenfalls in einem Durchbruch 26 ein Leuchtmittel eingesetzt, in diesem Fall eine Glühlampe 38, die nach oben hin durch die Glaskeramikplatte 12 strahlt.

Fig. 5 zeigt eine Ausführung einer aus zwei Feldern bestehenden Sensortaste. Der innere Abschnitt der Sensortaste 24a hat eine abgerundet quadratische Form und stellt die eigentliche Schalt-Taste dar, während ein diesen Abschnitt umgebender, im vorliegenden Fall quadratisch ringförmiger Abschnitt 24b eine Schaltfläche für einen sogenannten Überlaufschutz bildet. Um zu vermeiden, daß ein über die Berührungstaste hinweggeschobener oder geführter Gegenstand sie betätigt, ist die Auswertungsschaltung so vorgesehen, daß eine gleichzeitige oder aufeinanderfolgende Betätigung beider Bereiche 24a, 24b nicht zu einer Schaltung führt. Nur eine gezielte Berührung mit einem Finger in der Mitte, d.h. eine Betätigung nur der Schaltfläche 24a, führt zu einem Schaltergebnis. Auch diese Ausführung läßt sich mit der Sensortaste nach der Erfindung problemlos ausführen. Hier wäre es z.B. möglich, die gesamte Anordnung 24a, 24b oder andere speziell geformte oder angeordnete Abschnitte auf einer Folie vorzusehen, die bei der Aufbringung abgezogen wird.

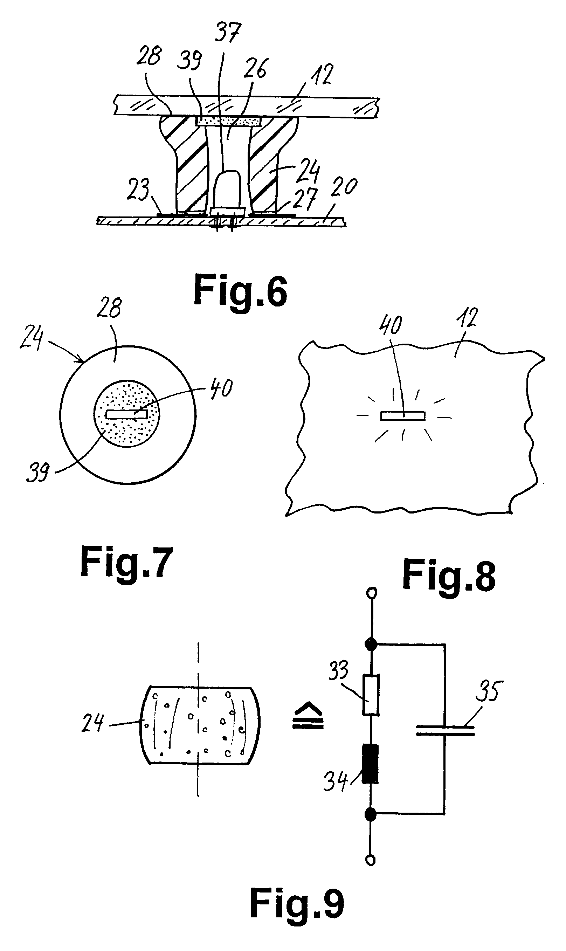

Die Querschnittsform der Tasten ist nicht nur auf runde oder quadratische beschränkt. Die Fig. 6 z.B. zeigt eine im Querschnitt kreisförmige, jedoch in der Seitenansicht etwa pilzförmige Sensortaste 24. Dabei ist die obere Sensorfläche 28 größer als die untere, an der Kontaktfläche 23 anliegende Anbringungsfläche, so daß die Sensortaste etwa Pilzform hat. Hierdurch kann nicht nur Platz auf der Platine 20 gespart werden, sondern besonders günstig eine Schablonenscheibe 39 zum Einsatz kommen. Diese ist in einen dementsprechend geformten Ausschnitt innerhalb der oberen Sensorfläche 28 am oberen Ausgang des Durchbruchs 26 eingesetzt. Von unten her wird sie durch die in dem Durchbruch 26 befindliche LED 37 beleuchtet.

In Fig. 7 ist eine Draufsicht auf das Sensorelement aus Fig. 6 dargestellt, wobei deutlich die mittig in die Sensorfläche 28 bzw. eine entsprechende Ausnehmung am oberen Ende des Durchbruchs 26 eingesetzte Schablonenscheibe 39 zu erkennen ist. Diese ist nicht auf eine in der Fig. 7 gezeigte runde Ausführung beschränkt, sondern kann beliebige Form annehmen. In der Mitte der Schablonenscheibe 39 befindet sich ein Symbol 40, das in diesem Fall ein Minuszeichen darstellt und als Ausschnitt ausgeführt ist. Ebenso wäre jedoch ein Einsatz aus einem unterschiedlich lichtdurchlässigen Material in Form des Symbols 40 möglich, wobei dieses Material vorzugsweise eine höhere Lichtdurchlässigkeit als die umgebende Schablonenscheibe 39 aufweist. Auf diese Weise besteht durch Beleuchtung der Schablonenscheibe 39 die Möglichkeit, von oben durch die Glaskeramikscheibe 12 erkennbar ein Symbol 40 darzustellen.

Das kann beispielsweise wie in Fig. 8 gezeigt aussehen. Hier stellt sich einem Benutzer, der die Glaskeramikplatte 12 von oben betrachtet, nur ein mehr oder weniger stark leuchtendes Symbol 40 dar. Dieses Symbol charakterisiert in diesem Fall ein Minuszeichen, und signalisiert dem Bediener, daß durch Berühren dieser Stelle mit dem Finger ein reduzierender Vorgang ausgelöst wird, beispielsweise eine Leistungsreduzierung. Ebenso könnte als Symbol eine Ziffer dargestellt werden, die z.B. eine eingestellte Leistungsstufe verkörpert.

Fig. 9 zeigt das Ersatzschaltbild einer Sensortaste 24, das aus einer Serienschaltung eines durch den elektrischen Widerstand in dem Körper der Sensortaste gebildeten Ersatzwiderstandes 33 und eines durch die Volumenausdehnung der Sensortaste entstehenden bzw. veränderbaren induktiven Widerstandes 34 besteht. In diesem Fall ist die Sensortaste entsprechend den Figuren 1 und 3 bis 6 teilweise zusammengedrückt. Zu der Serienschaltung der Widerstände 33 und 34 ist die Parallelkapazität 35 parallel geschaltet.

Aus diesem Ersatzschaltbild gehen weitere Vorteile der besonderen Ausformung der Sensortaste 24 hervor. Vor allem der Ersatzwiderstand 33 aber auch der induktive Widerstand 34 dämpfen Störeinflüsse von außen auf Sensortaste und Schaltung. Die Größe des induktiven Widerstandes kann durch Beimischung ferritischer Materialien beeinflußt werden. Die Volumenausdehnung der Sensortaste verbessert unter anderem dadurch dessen EMV-Eigenschaften erheblich gegenüber derzeit bekannten Sensorelementen, beispielsweise in flacher Form.

### Funktion

Zum Aufbau eines Kochgerätes wird in eine Blechmulde, d.h. eine flache Blechschale eine Anzahl von ihrerseits in flachen Blechschalen enthaltenen elektrischen Strahlungsheizkörpern eingelegt und mittels Federn an der Unterseite einer die Kochmulde überdeckenden Glaskeramikplatte 12 angedrückt. Ein Bereich der Glaskeramikplatte ist unbeheizt. In diesem Bereich ist die Steuer- und Regeleinheit 13, von dem eigenen Gehäuse 18 umschlossen, angeordnet. Durch ein entsprechendes Dekor der Glaskeramikplatte sind Schaltfelder für den Berührungsschalter ausgespart bzw. durch entsprechende Einfärbung markiert. Ebenso sind nicht dekorierte Felder für die Anzeigeelemente 16, 17 vorgesehen.

Zur Betätigung des Kochgerätes, und zwar entweder zur Einschaltung und/oder zur Einstellung eines bestimmten Leistungswertes berührt der Benutzer mit seinem Finger 30 ein Sensorfeld 31, das entweder als Aussparung in dem strichliert gezeigten Dekor 32 der Glaskeramikplatte angedeutet ist, das auf der Unter- oder Oberseite vorgesehen sein kann, oder durch ein in einem Durchbruch 26 in einer Sensortaste 24 angebrachtes Leuchtmittel angezeigt ist. Durch die damit erzeugte Kapazitätsänderung an der Sensortaste 24, die elektrisch an die Platine und damit an die Auswerteschaltung des Berührungsschalters 15 angeschlossen ist, wird die Schaltung ausgelöst. Als Auswertungsschaltung kann eine übliche Schaltung eines Berührungsschalters verwendet werden. Besonders vorteilhaft ist eine in der gleichzeitig eingereichten europäischen Patentanmeldung 98 10 1517.5 gezeigte und beschriebene Schaltung.

Das Ergebnis der Schaltung wird dem Benutzer über eine dadurch ausgelöste Änderung des in der Anzeige 16 angezeigten Zahlenwertes oder die Leuchtdiode 17 angezeigt. Alternativ dazu kann durch eine Änderung der Intensität oder der Leuchtfrequenz der Leuchtmittel in der Sensortaste ein Schaltungsergebnis mitgeteilt werden.

Es ist zu erkennen, daß die Erfindung eine kompakte Bauweise und Integration der Sensorschalter in die Schaltung ermöglicht. So kann beispielsweise die Anzeige 16 zwischen den einzelnen Sensortasten angebracht werden, ohne daß eine die Sensortasten tragende Platine die Anzeige behindert. Bevorzugtes Anwendungsgebiet ist das der Elektrokoch- und Wärmegeräte. Es ist jedoch auch möglich, die Erfindung bei anderen Berührungsschaltern anzuwenden, wobei die Abdeckplatte 12 dort beispielsweise von dem Frontpanel eines Betätigungsfeldes gebildet wird, das in beliebiger Lage angeordnet sein kann.

Der Durchbruch 26 beeinträchtigt die Funktion der Sensortaste 24 nicht, ebenso nicht darin vorgesehene Leuchtmittel. Dabei sollte die Fläche des Durchbruchs 26 oder einer Ausnehmung für eine Schablonenscheibe 39 weniger als die Hälfte der gesamten Querschnittsfläche der Sensortaste betragen, beispielsweise ca. 30 - 40 %.

## Patentansprüche

1. Kapazitiver Berührungsschalter mit einer Auswerteschaltung und einer unter der Unterseite einer Abdeckplatte (12) angeordneten mit Leiterbahnen versehenen Platine (20) und einer an die Abdeckplatte (12) angelegten Sensortaste (24), wobei die Sensortaste (24) einen Pol eines Kondensators bildet, der in seiner Kapazität durch Annäherung veränderbar ist, wobei die Sensortaste (24) einen Körper aus einem in sich flexiblen, räumlich ausgedehnten, raumformveränderlichen und elektrisch leitfähigen Material enthält, der eine an die Abdeckplatte (12) anpaßbare Oberfläche (28) aufweist, **dadurch gekennzeichnet, daß** die Sensortaste (24) aus dem Körper besteht, der ggf. unter Zwischenschaltung eines Klebers direkt auf einer metallischen Kontaktfläche (23) der die Schaltungsbauteile (14) für den Berührungsschalter (15) enthaltenden Platine (20) angebracht ist, wobei die Kontaktfläche (23) mit den Leiterbahnen auf der Platine (20) zusammen aufgebracht ist und daß der Körper den Abstand zwischen der Abdeckplatte (12) und der Platine (20) unter einer aufrechterhaltenen Druckspannung überbrückt.

2. Berührungsschalter nach Anspruch 1, **dadurch gekennzeichnet, daß** die Sensortaste (24) einen ohmschen Widerstand (33) und eine vergrößerte Induktivität aufweist, wobei dem Material der Sensortaste (24) zur Verbesserung des induktiven Widerstands (34) ferritische Materialien beigemischt sind.

3. Berührungsschalter nach einem der vorhergehenden Ansprüche, **dadurch gekennzeichnet, daß** die Sensortaste (24) wenigstens einen Durchbruch (26) aufweist, der in eine äußere Begrenzungsfläche der Sensortaste mündet, die vorzugsweise zur Abdeckplatte (12) des Berührungsschalters hin weist, wobei der Durchbruch (26) im wesentlichen geradlinig ausgeführt ist und insbesondere wenigstens ein Leuchtmittel (37) in ihm angeordnet ist.

4. Berührungsschalter nach Anspruch 3, **dadurch gekennzeichnet, daß** die Sensortaste (24) eine Ausnehmung, insbesondere an der der Abdeckplatte (12) zugewandten Begrenzungsfläche mit dem Durchbruch (26), zur Befestigung und/oder Aufnahme einer Schablonenscheibe (39) mit einem ein Symbol (40) darstellenden Ausschnitt oder mit verschiedenartig lichtdurchlässigen Einsätzen aufweist.

5. Berührungsschalter nach einem der vorhergehenden Ansprüche, **dadurch gekennzeichnet, daß** die Sensortaste (24) elektrisch leitfähiges Kunststoff- oder Gummimaterial enthält, wobei sie vorzugsweise hauptsächlich aus elektrisch leitfähigem Schaumstoff besteht.

6. Berührungsschalter nach einem der vorhergehenden Ansprüche, **dadurch gekennzeichnet, daß** die Sensortaste (24) zwischen ihrer Kontaktierung und ihrem davon am weitesten entfernten Ende einen elektrischen Widerstand bis 500 Kiloohm aufweist.

7. Berührungsschalter nach einem der vorhergehenden Ansprüche, **dadurch gekennzeichnet, daß** die Platine (20) mehrere Berührungsschalter aufnimmt.

8. Berührungsschalter nach einem der vorhergehenden Ansprüche, **dadurch gekennzeichnet, daß** die Sensortaste (24) mittels eines leitfähigen Klebers (27) oder Doppelklebebandes an ihrer Kontaktfläche (23) und/oder der Abdeckplatte (12), unter der sie angeordnet ist, angebracht ist.

9. Berührungsschalter nach einem der vorhergehenden Ansprüche, **dadurch gekennzeichnet, daß** die Sensortaste (24) auf einen Befestigungsstift (25) aufgesteckt ist.

10. Berührungsschalter nach einem der vorhergehenden Ansprüche, **dadurch gekennzeichnet, daß** die Sensortaste (24) einen einstückigen Körper aufweist, insbesondere einen im wesentlichen zylinderförmigen Körper mit einem runden Durchbruch (26) entlang ihrer Mittelachse zwischen Abdeckplatte (12) und Platine (20), wobei in dem Durchbruch (26) eine LED (37) zur optischen Kennzeichnung enthalten ist.

## Claims

1. Capacitive touch contact switch with an evaluating circuit and a mounting board (20), provided with conductors, placed under the underside of a cover plate (12) and a sensor button (24) applied to the cover plate (12), the sensor button (24) forming one pole of a capacitor, whose capacitance is variable by approach, the sensor button (24) containing a body made from an intrinsically flexible, spatially extended, three-dimensionally variable and electrically conductive material, which has a surface (28) adaptable to the cover plate (12), **characterized in that** the sensor button (24) comprises the body which, optionally accompanied by the interposing of an adhesive, is directly applied to a metallic contact face (23) of the mounting board (20) containing the circuit components (14) for the touch contact switch (15), in which the contact face (23) is applied together with the conductors to the mounting board (20) and that the body bridges the space between the cover plate (12) and the mounting board (20) under a maintained compressive stress.

2. Touch contact switch according to claim 1, **characterized in that** the sensor button (24) has an ohmic resistor (33) and an increased inductance, ferritic materials being admixed with the material of the sensor button (24) for improving the inductive resistor (34).

3. Touch contact switch according to one of the preceding claims, **characterized in that** the sensor button (24) has at least one opening (26) issuing into an outer boundary surface of the sensor button, which is preferably directed towards the cover plate (12) of the touch contact switch, the opening (26)being substantially linear and in particular at least one lighting means (37) is located therein.

4. Touch contact switch according to claim 3, **characterized in that** the sensor button (24) has a recess, particularly on the boundary surface facing the cover plate (12) with the opening (26) for fixing and/or receiving a symbol disk (39) with a cutout representing a symbol (40) or with different, light-permeable inserts.

5. Touch contact switch according to one of the preceding claims, **characterized in that** the sensor button (24) contains electrically conductive plastic or rubber material and is preferably mainly made from electrically conductive foam.

6. Touch contact switch according to one of the preceding claims, **characterized in that** the sensor button (24) between its contacting and its end furthest remote therefrom has an electrical resistance up to 500 kiloohms.

7. Touch contact switch according to one of the preceding claims, **characterized in that** the mounting board (20) receives several touch contact switches.

8. Touch contact switch according to one of the preceding claims, **characterized in that** the sensor button (24) is fitted by means of a conductive adhesive (27) or double adhesive tape to its contact face (23) and/or the cover plate (12) under which it is located.

9. Touch contact switch according to one of the preceding claims, **characterized in that** the sensor button (24) is mounted on a fixing pin (25).

10. Touch contact switch according to one of the preceding claims, **characterized in that** the sensor button (24) has a one-piece body, particularly a substantially cylindrical body with a round opening (26) along its centre axis between the cover plate (12) and the mounting board (20), the opening (26) containing a LED (37) for optical marking purposes.

## Revendications

1. Commutateur de proximité capacitif avec un circuit d'évaluation et une plaquette à circuit imprimé (20) pourvue d'un circuit conducteur et disposée au-dessous de la face inférieure d'une plaque de recouvrement (12), et une touche à capteur (24) appliquée à la plaque de recouvrement (12), la touche à capteur (24) constituant un pôle d'un condensateur qui est modifiable par approche dans sa capacité électrique, la touche à capteur (24) comprenant un corps en un matériau flexible en soi-même, présentant une étendue dans l'espace, pouvant être modifié dans sa forme volumétrique et étant électriquement conductible, lequel corps présente une surface (28) pouvant être adaptée à la plaque de recouvrement (12), **caractérisé en ce que** la touche à capteur (24) est constituée par le corps, lequel est placé, éventuellement sous intercalation d'une matière adhésive, directement à une surface de contact (23) métallique de la plaquette à circuit imprimé (20) laquelle comprend les composants de circuit (14) pour le commutateur de proximité (15), la surface de contact (23) étant appliquée ensemble avec les circuits conducteurs sur la plaquette à circuit imprimé (20), et **en ce que** le corps franchit l'écart entre la plaque de recouvrement (12) et la plaquette à circuit imprimé (20) sous une contrainte de compression maintenue.

2. Commutateur de proximité d'après la revendication 1, **caractérisé en ce que** la touche à capteur (24) présente une résistance ohmique (33) et une inductance agrandie, des matériaux ferritiques étant additionnés au matériau de la touche à capteur (24) pour une amélioration de la résistance inductive (34).

3. Commutateur de proximité d'après une des revendications précédentes, **caractérisé en ce que** la touche à capteur (24) présente au moins une ouverture (26) débouchant sur une surface extérieure de délimitation de la touche à capteur, laquelle est orientée de préférence en direction de la plaque de recouvrement (12) du commutateur de proximité, l'ouverture (26) étant réalisée essentiellement de manière rectiligne et notamment au moins un élément lumineux (37) étant disposé à l'intérieur de celle-ci.

4. Commutateur de proximité d'après la revendication 3, **caractérisé en ce que** la touche à capteur (24) présente un creux notamment à la surface de délimitation avec l'ouverture (26), orientée vers la plaque de recouvrement (12), pour la fixation et/ou pour le logement d'une plaque de cache (39) avec un secteur représentant un symbole (40) ou bien avec des inserts présentant différents genres de transparence.

5. Commutateur de proximité d'après une des revendications précédentes, **caractérisé en ce que** la touche à capteur (24) contient de la matière plastique ou caoutchouteuse électriquement conductible, étant composée de préférence principalement d'une mousse électriquement conductible.

6. Commutateur de proximité d'après une des revendications précédentes, **caractérisé en ce que** la touche à capteur (24) présente entre ses connexions et son extrémité la plus écartée de ceci une résistance électrique jusqu'à 500 kiloohm.

7. Commutateur de proximité d'après une des revendications précédentes, **caractérisé en ce que** la plaquette à circuit imprimé (20) loge plusieurs commutateurs de proximité.

8. Commutateur de proximité d'après une des revendications précédentes, **caractérisé en ce que** la touche à capteur (24) est placée au moyen d'une matière adhésive (27) conductible ou d'un ruban adhésif des deux côtés, à sa surface de contact (23) et/ou à sa plaque de recouvrement (12), au-dessous de laquelle elle est disposée.

9. Commutateur de proximité d'après une des revendications précédentes, **caractérisé en ce que** la touche à capteur (24) est embrochée sur une cheville de fixation (25).

10. Commutateur de proximité d'après une des revendications précédentes, **caractérisé en ce que** la touche à capteur (24) présente un corps monobloc, notamment un corps de forme essentiellement cylindrique avec une ouverture (26) ronde le long de son axe médian entre la plaque de recouvrement (12) et la plaquette à circuit imprimé (20), une diode électroluminescente (37) pour le signalement optique étant contenue dans l'ouverture (26).
